# EUROPÄISCHE PATENTSCHRIFT

(11) **EP 0 980 836 B1**
(45) Veröffentlichungstag und Bekanntmachung des Hinweises auf die Patenterteilung: **18.02.2004**
(21) Anmeldenummer: 99890265.4
(22) Anmeldetag: 06.08.1999
(51) Int. Cl.: B65D 90/64, B65D 88/12

(54) **Wechselbehälter oder LKW Aufbauten in Form von geschlossenen Ladekasten für Kranbeladung**
Interchangeable container or lorry superstructures shaped as closed box for crane loading
Conteneur interchangeable ou superstructures de camions sous forme de caisson clos pour chargement par grue

(30) Priorität: 07.08.1998 AT 136698
(43) Veröffentlichungstag der Anmeldung: 23.02.2000
(73) Patentinhaber: Feurstein, Günther, 8724 Spielberg (AT)
(72) Erfinder: Feurstein, Günther, 8724 Spielberg (AT)

(56) Entgegenhaltungen:
- DE-A- 1 930 653
- DE-A- 2 132 772
- US-A- 4 603 787

## Beschreibung

Die vorliegende Erfindung bezieht sich auf eine Wechselpritsche oder LKW-Aufbau in Form eines geschlossenen Ladekastens, bei dem mindestens eine Seitenwand und das Dach über die gesamte Länge zu öffnen sind, wobei im geöffneten Zustand der gesamte Bereich der offenen Seitenwand und des Daches für die Beladung freigebbar ist.

Aus der US 4 603 787 A ist ein Container bekannt bei dem die Vorderwand des Containers um eine Achse in Längsrichtung des Containers aufgeklappt und das. Dach durch zwei Schiebeplatten freigegeben werden kann. Zur Vollständigen Freigabe der Vorderwand und des Daches müssen jedoch die Vorderwandklappe aus der Lagerung herausgehoben und die Schiebeplatten herausgezogen werden.

Die Aufgabe der vorliegenden Erfindung besteht darin, Wechselpritschen oder LKW Aufbauten in der Form von geschlossenen Ladekasten nicht nur seitlich, sondern auch am Dach über die gesamte Länge öffnen zu können.

Diese Aufgabe wird ausgehend von der eingangs genannten Wechselpritsche oder LKW-Aufbau erfindungsgemäß durch die kennzeichnenden Merkmale des Anspruchs 1 gelöst.

Das wesentliche Merkmal besteht darin, dass kein Querträger oder Längsträger im offenen Zustand bei den Ladetätigkeiten hinderlich ist.

Weitere Merkmale und vorteilhafte Ausgestaltungsformen der erfindungsgemäßen Wechselpritsche oder LKW-Aufbau gehen aus den abhängigen Unteransprüchen hervor bzw. sind den nachstehenden Erläuterungen und der Beschreibung eines Ausführungsbeispieles zu entnehmen, wobei die Nummerierung der Teile mit den in den Figuren verwendeten Bezugszeichen übereinstimmt.

Um ein Absinken der faltbaren Seitenwände 2 beim Öffnen zu verhindern laufen die Rollen in den im Boden verlaufenden Schienen 21.

Das Öffnen der Seitenwände 2 erfolgt so, dass nach dem Öffnen der Verschlüsse 23 in der Seitenwand 2 sich das erste Drittel wie eine Tür öffnen lässt. Danach lässt sich die Seitenwand falten und nach hinten bzw. vorne zusammenschieben, wonach sich die Elemente schwenken lassen, bis sie zur Längsrichtung zum Stehen kommen.

Das Dach 1 wird in zwei Hälften geteilt und jeweils in 4 Segmenten über die Längsseite zusammengefaltet. In den beiden äußeren Segmenten ist eine Schiene 13 integriert, die als Führung für die Rollen 27 der Seitenwände 2 dient. Beim Öffnen der Verriegelung wird das äußere Dachsegment 12 mittels eines Hebels 9 über den vorderen und mittleren Querträger 6 (vordere Hälfte) und über den mittleren sowie den hinteren Querträger ( hintere Hälfte des Daches) angehoben, sodass sich die Elemente ober den Querträgern zusammenfalten lassen.

Der mittlere Querträger 6 und die Mittelsäule ( (Steher) sind vorzugsweise in einem und lassen sich nach dem Entriegeln nach hinten oder vorne verschieben. Das Verschieben des Stehers mit dem Querträger wird dadurch ermöglicht, dass beim Öffnen, mittels eines Hebels 23 des Verschlusses 16, der Steher 6 durch die Zurrstange 20 angehoben wird und die Zurrstange mit den Laufrollen fix verbunden ist. Dadurch läßt sich der Steher 6 mit dem Querträger verschieben. Das Verriegeln des Stehers 6 mit dem Querträger geschieht so, dass die obere Verriegelung 16 sowie die untere Verriegelung 19 - Laufrollen 18 sind mit der Zurrstange 20 verbunden - mittels des Hebels 23 mit dem oberen Längsträger 14 und den Seitenrahmen 25 verbunden bzw . verzurrt wird. Am Steher 6 sind unten 2 Zentrierzapfen 22 angebracht die im Seitenrahmen einrasten um ein seitliches Verrutschen zu vermeiden.

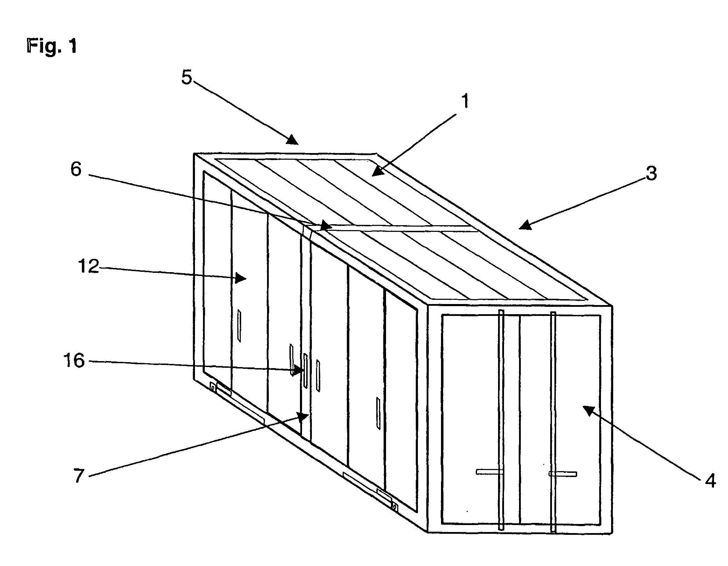

Fig.1 zeigt die Wechselpritsche im geschlossenen Zustand.

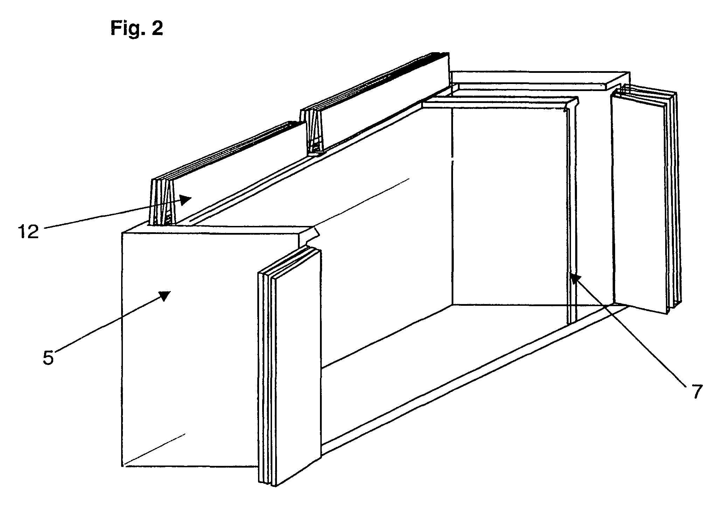

Fig.2 zeigt die Wechselpritsche im offenen Zustand.

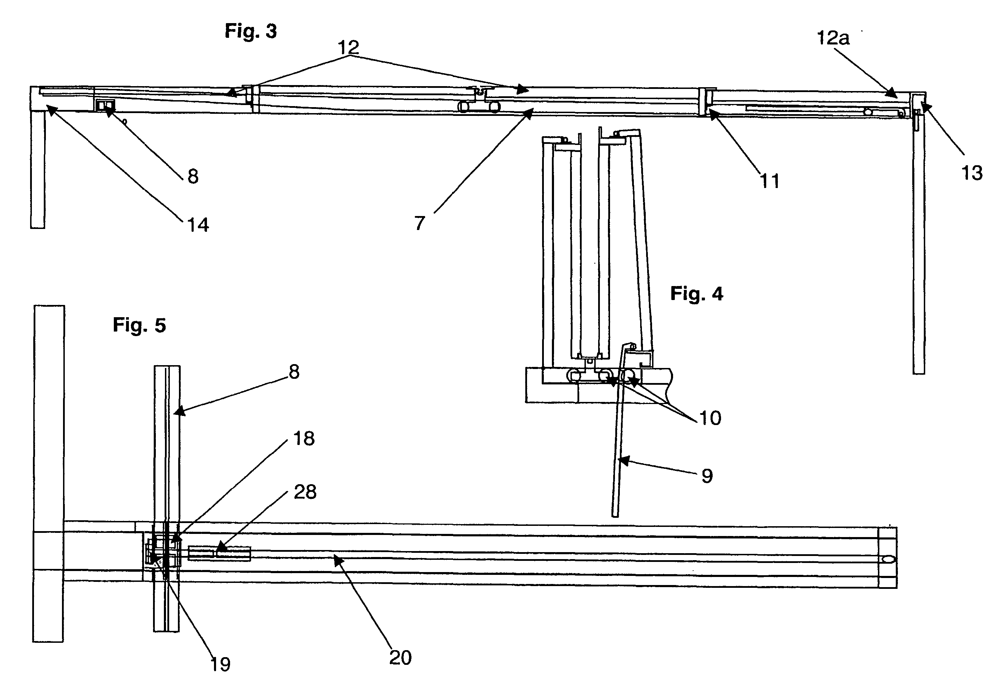

Fig. 3 zeigt das Dach 1 geschlossen und Fig. 4 zeigt wie sich das Dach 1 zusammenfalten läßt.

Fig. 5 zeigt den fixen Längsträger 14 mit der Führungsschiene 8 in dem sich der Querträger nach hinten verschieben läßt.

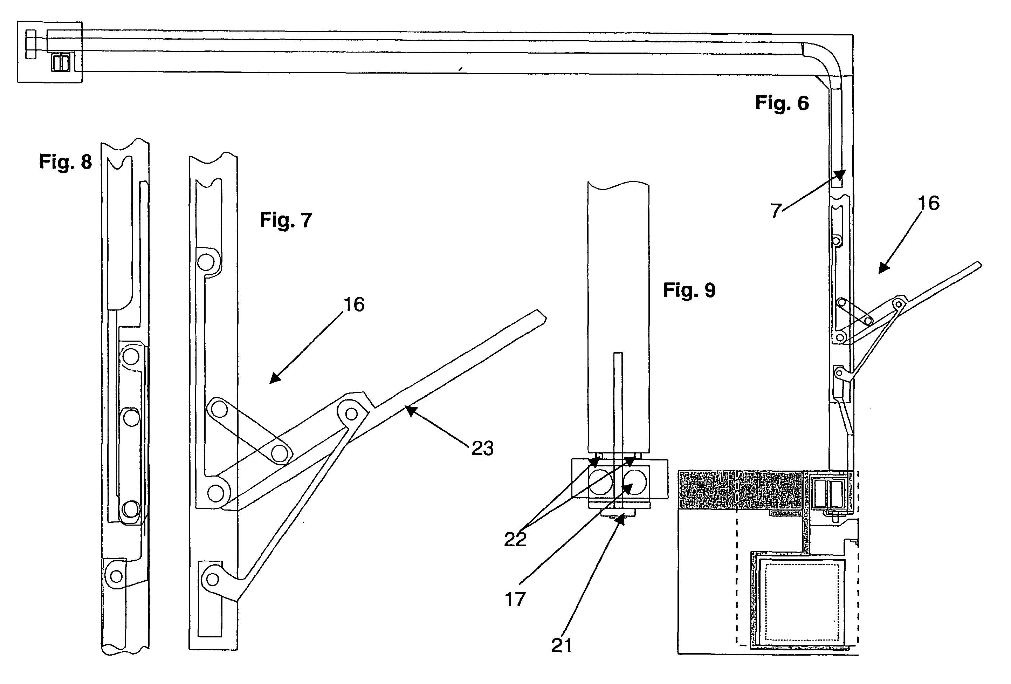

Fig. 6 zeigt den Steher und den Querträger mit den Laufrollen für den Steher 6 und den Laufrollen für den Querträger 6 sowie die obere Verriegelung 16 und die untere Verriegelung 19 und die Stellschraube 23.

Fig. 7 zeigt den Verschluß (16) für den Steher (7) im geöffneten Zustand.

Fig. (8) zeigt diesen im geschlossenen Zustand.

Fig.9 zeigt den Steher (7) mit den Laufrollen (17) und der Verriegelung (21) sowie den Zentrierzapfen (22)

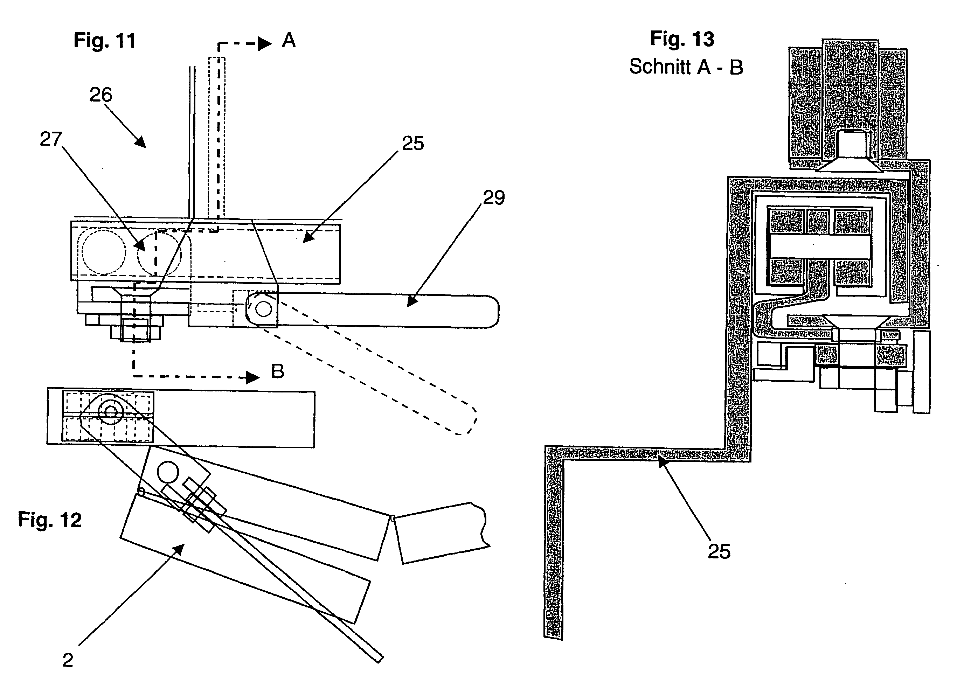

Fig. 11 zeigt den Verschluß (26) der Seitenwand (2) und deren Laufrollen (27).

Fig. 12 zeigt wie sich die Seitenwand öffnen läßt.

Fig. 13 zeigt den Schnitt A-B vom Verschluß (26).

Teileverzeichnis. Dach **1**, Seitenwand links **2**, Seitenwand rechts **3**, hinteres Portal **4**, Vorderwand **5**, Querträger **6**, Steher **7**, Führungsschiene für Querträger (6) = **8**, Hebel zum Öffnen des Dachs (1) = **9** Laufrollen des Dachs (1) = **10**, Scharniere der Segmente (12) = **11**, Segmente des Dachs (1) = **12,** Längsführung des äußeren Dachsegmentes (12a) = **13**, Längsträger der die Vorderwand (5) mit dem hinteren Portal (4) verbindet = **14**, das Verbindungsstück von der Verriegelung (21) zu dem Verschluß (16) = **15**, der Verschluß des Stehers (7) = **16,** die Laufrollen von diesen = **17**, die Laufrollen des Querträgers = **18,** der Verschluß des Querträgers (6) = **19**, die Zurrstange = **20**, die Verriegelung des Stehers (7)= **21** Die Zentrierzapfen **22,** Hebel zum Öffnen des Verschlusses (16) = **23** biegsame Welle über die Ecke vom Querträger (6) zum Steher (7)= **24,** Seitenrahmen = **25,** Verschluß für Seitenwand (2) = **26** deren Laufrollen = **27**, Stellschraube für die Zurrstange (20) = **28.**

## Patentansprüche

1. Wechselpritsche oder LKW-Aufbau in Form eines geschlossenen Ladekastens, bei dem mindestens eine Seitenwand (2, 3) und das Dach (1) über die gesamte Länge zu öffnen sind, wobei im geöffneten Zustand der gesamte Bereich der offenen Seitenwand (2, 3) und des Daches (1) für die Beladung freigebbar ist, **dadurch gekennzeichnet, dass** die Wechselpritsche oder der LKW-Aufbau durch einen "L-förmigen Bauteil" unterteilt ist, welcher aus dem mittleren Querträger (6) des Dachs (1) und der mittleren Stütze (7) der Seitenwand (2, 3) besteht.

2. Wechselpritsche oder LKW-Aufbau nach Anspruch 1, **dadurch gekennzeichnet, dass** der L-förmige Bauteil einteilig ist.

3. Wechselpritsche oder LKW-Aufbau nach Anspruch 1 oder 2, **dadurch gekennzeichnet, dass** die Seitenwände (2, 3) in mehrere Segmente unterteilt sind und sich zum vorderen oder zum hinteren Ende des Behälters zusammenfalten lassen und nach dem vollständigen Zusammenfalten in Längsrichtung wegklappen lassen.

4. Wechselpritsche oder LKW-Aufbau nach Anspruch 1, 2 oder 3, **dadurch gekennzeichnet, dass** sich das erste Segment der Seitenwände (2) wie eine Tür öffnen läßt und danach sich die Segmente wie ein Z zusammenfalten lassen.

5. Wechselpritsche oder LKW-Aufbau nach einem der Ansprüche 3 oder 4, **dadurch gekennzeichnet, dass** die Verschlußhebel (29) der Seitenwände unten angebracht sind, so dass diese beim Schwenken nicht hinderlich sind.

6. Wechselpritsche oder LKW-Aufbau nach einem der Ansprüche 3 bis 5, **dadurch gekennzeichnet, dass** die Seitenwände (2) mittels Rollen (27) in Schienen (30) an der unteren Längsseite gelagert sind und an der oberen Längsseite am Ende des äußeren Dachelementes (12a) in Führung geführt sind.

7. Wechselpritsche oder LKW-Aufbau nach einem der Ansprüche 1 bis 6, **dadurch gekennzeichnet, dass** das Dach in 2 Hälften geteilt ist wobei jede der beiden Hälften aus mehreren Segmenten (12) besteht welche zur Längsseite des Dachs, die der geöffneten Seitenwand gegenüberliegt, zusammengefaltet werden können.

8. Wechselpritsche oder LKW-Aufbau nach Anspruch 7, **dadurch gekennzeichnet, dass** sich auf einer Längsseite ein durchgehender Träger (14) befindet wo das zusammenfaltbare Dach montiert ist.

9. Wechselpritsche oder LKW-Aufbau nach einem der Ansprüche 7 oder 8, **dadurch gekennzeichnet, dass** die Drehachse des Hebels (9) , in der an deren Enden Laufrollen (10) angeordnet sind, von dem äußeren Rand des äußersten Dachsegment (12a) soweit distanziert ist, dass das äußerste Dachsegment beim Herunterklappen des Hebels (9) über die Oberkante des mittleren Querträger (6) und der Oberkante der Vorderwand bzw. dem hinteren Portal angehoben werden kann, dadurch wird das Zusammenfalten der Dachelemente möglich.

10. Wechselpritsche oder LKW-Aufbau nach einem der Ansprüche 1 bis 9, **dadurch gekennzeichnet, dass** der L-förmige Bauteil entriegelbar in der Mitte des Aufbaus angebracht ist und nach dem Zusammenfalten der Seitenwände (2) und des Dachs (1) zum vorderen oder zum hinteren Ende der Wechselpritsche oder des LKW Aufbaus verschiebbar ist.

11. Wechselpritsche oder LKW-Aufbau nach einem der Ansprüche 1 bis 10, **dadurch gekennzeichnet, dass** in dem L- förmigen Bauteil der unten und oben auf Rollen gelagert ist ein Hebel (23) eingebaut ist, der nach dem Entriegeln das untere Ende des Bauteiles mittels einer Zurrstange (20) die mit dem Hebel verbunden ist, anhebt, so dass die am unteren Ende des Bauteils vorhandenen Zentrierzapfen frei werden, wobei der L-förmige Bauteil = (6 +7) nach hinten oder vorne verschiebbar ist.

12. Wechselpritsche oder LKW-Aufbau nach Anspruch 9, , **dadurch gekennzeichnet, dass** in dem durchgehenden Längsträger (14) eine weitere Schiene (8) angebracht ist, wo der L- förmige Bauteil mit den Rollen (18) geführt wird.

## Claims

1. Changeable platform or car body in the shape of a compact container, where at least one side wall (2,3) and the top (1) can be opened overall length, additionally possible to load the whole container as the top and the side wall can be folded, characteristic of a subdivided "L-shaped part", which consists of a crossbeam (6) in the middle of the top (1) and the central pillar (7) of the side wall (2,3).

2. Changeable platform or car body according to claim 1 or 2, characteristic of the "L-shaped component part in one piece.

3. Changeable platform or car body according to claim 1 or 2, characteristic of several subdivided segments of the side walls (2,3), which can be folded from the front to the back alongside the container and which can be folded aside afterwards.

4. Changeable platform or car body according to claim 1,2 or 3, characteristic of a first segment in the side walls (2), which can be opened like a door and further segments that can be folded like a Z.

5. Changeable platform or car body according to one of claims 3 - 5, typical of a bottom fixed closure (29) of the side walls not hindering when turning.

6. Changeable platform or car body according to one of claims 3 - 5, characteristic of side walls (2) running in a bearing by rollers (27) in guide ways (30) along the lower side and in a guide way along the upper side at the end of the outer element of the top (12a)

7. Changeable platform or car body according to one of claims 1 - 6, characteristic of a divided top. Each half of the top, consisting of several segments (12) and placed opposite the open side wall, can be folded.

8. Changeable platform or car body according to claim 7, characteristic of a continuous beam (14) alongside, where the foldable top is fitted.

9. Changeable platform or car body according to claim 7 or 8, characteristic of a fulcrum shaft axle of the lever (9), in which rollers are fixed at the end and which is placed at a certain distance of the outer side of the farthest top segment (12a), so that the farthest top segment can be lifted above the upper edge of the central cross beam (6) and the upper edge of the front wall/back door, when the lever (9) is put down. In this manner it is possible to fold the segments of the top.

10. Changeable platform or car body according to one of claims 1 - 9, characteristic of the "L-shaped" component part, to be opened in the centre of the car body and movable from the front to the back end of the platform after having folded the side walls (2) and the top (1).

11. Changeable platform or car body according to one of claims 1 - 10, characteristic of a lever (23), installed in the "L-shaped" component part (on top and bottom rollers running in a bearing), which can lift the lower end of the component part with the help of a lash bar, connected with the lever, after opening. So the centre plugs at the lower end of the component part are set free and the "L-shaped" component part (6+7) can be moved to the front or to the back.

12. Changeable platform or car body according to claim 9, characteristic of a further guide way (8), placed in the continuous longitudinal beam (14), for the running of the "L-shaped" component part with the rollers (18).

## Revendications

1. La benne modulable ou structure de camion sous forme d'une caisse de chargement fermée, sont ouvrables au minimum sur une paroi latérale (2,3) et le toit (1) sur toute la longueur, afin qu'en position ouverte de l'ensemble de la partie de la paroi latérale ouverte (2,3) et du toit (1)soit libéré pour le chargement, se **caractérise** en cela, que la benne modulable ou la structure de camion est subdivisée par une pièce de construction en forme de L, laquelle se compose de la barre transversale intermédiaire (6) du toit (1) et du support intermédiaire de la paroi latérale (2,3).

2. La benne modulable ou structure de camion suivant l'exigence 1, se **caractérise par le fait que** la pièce de construction en forme de L est en un élément.

3. La benne modulable ou structure de camion suivant l'exigence 1 ou 2, se **caractérise** en cela, que les parois latérales (2,3) sont divisées en plusieurs segments et se laissent plier ensemble aux extrémités avant et arrière du container et se laissent démonter après avoir été pliés ensemble complètement dans le sens de la longueur

4. La benne modulable ou structure de camion suivant l'exigence 1, 2 ou 3, se **caractérise par le fait, que** le premier segment de la paroi latérale (2) peut s'ouvrir comme une porte et après quoi les segments se laissent replier ensemble sous forme de Z.

5. La benne modulable ou structure de camion suivant une des exigences 3 ou 4, , se **caractérise par le fait, que** les leviers de fermeture (29) des parois latérales sont placés de telle manière afin de ne pas gêner pendant la manoeuvre de déplacement.

6. La benne modulable ou structure de camion suivant une des exigences 3 à 5, se **caractérise** du fait que les parois latérales (2) au moyen des rouleaux (27) dans les rails (30) sont rangés sur le côté de la longueur inférieur et sont dirigés à l'avant des bords de la longueur supérieur au bout de l'élément du toit extérieur (12a).

7. La benne modulable ou structure de camion suivant une des exigences 1 à 6, se **caractérise** du fait que le toit est divisé en deux moitiés telles que chacune des deux moitiés se composent de plusieurs segments (12) lesquels peuvent être pliés ensemble sur le côté de la longueur du toit, qui se trouvent en face de la paroi latérale ouverte.

8. La benne modulable ou structure de camion suivant l'exigence 7, se **caractérise** du fait qu'un support traversant sur un coté de la longueur se situe là où le toit pliable est monté.

9. La benne modulable ou structure de camion suivant une des exigences 7 ou 8, se **caractérise par le fait que** les axes tournants du levier (9), au bout desquels les rouleaux mobiles (10) sont placés, du bord extérieur le plus à l'extérieur du segment de toit (12a), est mis à une telle distance que le segment extérieur du toit peut être levé lors de l'abaissement du levier (9) à travers les bords supérieurs du support transversal moyen (6) et aux bords supérieurs du mur avant en particulier au portail arrière, grâce à cela le pliage des segments du toit est rendu possible.

10. La benne modulable ou structure de camion suivant une des exigences 1 à 9, se **caractérise par le fait que** l'élément de construction en forme de L qui est situé au milieu de la structure, est déverrouillable et après repliement de l'ensemble des parois latérales (2) et du toit (1) est déplaçable aux extrémités avant et arrière des bennes modulables ou structures de camion.

11. La benne modulable ou structure de camion suivant une des exigences 1 à 10, se **caractérise** du fait qu'un levier (23) est construit dans la pièce de construction en forme de L, qui est placé dessous et dessus sur rouleaux, qui après déverrouillage l'extrémité inférieure de la pièce de construction au moyen d'une « tige (Zurrstange) » (20) qui est relié avec le levier, se lève, afin de libérer les tiges de centrage existantes à l'extrémité inférieure de la pièce de construction, à quoi la pièce de construction en forme de L = (6+7) est déplaçable vers l'arrière ou l'avant

12. La benne modulable ou structure de camion suivant l'exigence 9, se **caractérise** du fait qu'un rail (8) supplémentaire est fixé dans le support longitudinal traversant (14), où la pièce de construction en forme de L est dirigé avec les rouleaux.
